# FASCICULE DE BREVET EUROPEEN

(11) **EP 0 960 473 B1**
(45) Date de publication et mention de la délivrance du brevet: **05.12.2001**
(21) Numéro de dépôt: 98905466.3
(22) Date de dépôt: 30.01.1998
(51) Int. Cl.: H03D 7/16

(54) **CIRCUIT DE TRAITEMENT ANALOGIQUE DE SIGNAL POUR RECEPTEUR DE POSITIONNEMENT PAR SATELLITE**
SCHALTUNG ZUR ANALOGSIGNALVERARBEITUNG FÜR EMPFÄNGER VON SATELLITENPOSITIONSSIGNALEN
SIGNAL ANALOG PROCESSING CIRCUIT FOR SATELLITE POSITIONING RECEIVER

(30) Priorité: 31.01.1997 FR 9701075
(43) Date de publication de la demande: 01.12.1999
(73) Titulaire: THALES AVIONICS S.A., 78141 Vélizy Villacoublay Cédex (FR)
(72) Inventeur: RENARD, Alain, Thomson-CSF S.C.P.I., F-94117 Arcueil Cedex (FR); SUAUD, Nelly, Thomson-CSF S.C.P.I., F-94117 Arcueil Cedex (FR)
(74) Mandataire: Guérin, Michel
(86) Numéro de dépôt international: FR9800175
(87) Numéro de publication internationale: WO9834340

(56) Documents cités:
- EP-A- 0 285 252
- EP-A- 0 351 156
- DE-A- 2 623 784
- GB-A- 2 289 809
- US-A- 4 851 787
- CHESTER D B ET AL: "SINGLE CHIP DIGITAL DOWN CONVERTER SIMPLIFIES RF DSP APPLICATIONS" RF DESIGN, vol. 15, no. 12, pages 39-40, 42 - 46, XP000361671

## Description

L'invention concerne les récepteurs de positionnement par satellite tels que les récepteurs GPS (Global Positionning System) ou GLONASS (Global Navigation Satellite System).

Ces systèmes utilisent une constellation de satellites qui tournent autour de la terre sur des orbites très précisément déterminées, c'est-à-dire qu'on peut connaître à tout instant la position d'un satellite quelconque. Les satellites émettent des signaux radiofréquences contenant des données de navigation et des codes qui permettent d'identifier chaque satellite. Ces codes modulent en phase (modulation BPSK) une fréquence porteuse. Un récepteur, au sol ou sur un véhicule terrestre, aérien ou maritime, peut recevoir les signaux de plusieurs satellites simultanément, calculer précisément sa distance à chacun des satellites, et en déduire sa position précise en latitude, longitude, et altitude, dans un repère terrestre. Il peut en déduire aussi la date et l'heure précise de la réception dans le repère temporel du système. Il peut enfin en déduire, par des mesures doppler, son propre vecteur vitesse dans le repère terrestre (cas d'un récepteur monté sur un véhicule mobile).

Un tel système est divulgué par le document GB-A-2 289 809.

Le système GPS, comme le système GLONASS, utilise deux bandes de fréquences radio distinctes correspondant respectivement à une application civile (fréquences L1) et une application militaire (fréquences L2). Pour le système GPS, il n'y a qu'une fréquence L1, égale à 1575,42 MHz et qu'une fréquence L2, égale à 1227,60 MHz. Pour le système GLONASS, il y a une fréquence L1 différente pour chaque satellite de la constellation, et, également, une fréquence L2 différente pour chaque satellite; on peut considérer que la bande L1 de Glonass, compte tenu de son état actuel et de ses évolutions futures, s'étend de 1590 MHz à 1620 MHz. La bande L2 s'étend entre 1238 et 1265 MHz.

La détection des signaux d'un satellite se fait en recherchant un code de modulation de phase présent dans le signal radio. Les signaux du satellite sont reçus par une antenne et envoyés à un circuit analogique qui transpose la fréquence radio modulée en une fréquence plus basse modulée de la même manière, et qui convertit en numérique le signal transposé avant de l'envoyer à un circuit de traitement numérique de signal. C'est le circuit de traitement numérique qui détecte la présence du code, en le corrélant avec un code identique généré localement, et qui déduit, à partir de la position temporelle du code local, des informations de pseudo-distances permettant ensuite de déterminer la position du récepteur.

On comprendra que le circuit analogique doit permettre de transposer la fréquence du signal radio, sans perdre sa modulation, jusqu'à une fréquence suffisamment basse pour que le signal transposé puisse être traité dans le circuit de traitement numérique de signal. Ce dernier est un circuit intégré à base de silicium dont la fréquence de travail est limitée à quelques dizaines de mégahertz.

Un des buts de l'invention est de concevoir les circuits internes du récepteur d'une manière telle qu'il soit facile d'adapter un même circuit à la réalisation de récepteurs de types différents et d'applications différentes.

Par "type de récepteur", on entend le fait que le récepteur est spécialisé pour le système GPS ou spécialisé pour le système GLONASS, ou encore mixte, c'est-à-dire capable de recevoir au choix les signaux de l'un ou l'autre des deux systèmes.

Par "application", on entend principalement le fait que le récepteur peut recevoir seulement les signaux de la bande de fréquence civile L1 ou au contraire peut recevoir aussi les signaux de la bande L2.

On voudrait donc, pour réduire les coûts de dévelopement des récepteurs, que les circuits internes de ces récepteurs soient capables, dans le cas le plus simple, de fonctionner uniquement en système GPS sur la fréquence civile L1, ou, dans le cas le plus compliqué, de fonctionner avec les bandes L1 et L2 du système GPS et du système GLONASS. Et bien sûr, ces circuits devraient aussi pouvoir servir pour toutes les applications intermédiaires, par exemple un récepteur uniquement civil (fréquences L1) susceptible de recevoir aussi bien des signaux GPS que des signaux GLONASS.

Des circuits de traitement numérique de signal peuvent être conçus pour fonctionner aussi bien avec des satellites GLONASS qu'avec des satellites GPS, bien que les solutions pour y parvenir ne soient pas simples.

L'invention concerne le circuit analogique de transposition de fréquence et de conversion analogique-numérique qui précède les circuits de traitement numérique de signal. Un but de l'invention est de faciliter la réalisation de la transposition de fréquence en rendant cette réalisation la plus indépendante possible du type de récepteur et de l'application envisagée.

Pour des raisons tenant à la protection contre les perturbations créées par les signaux radioélectriques de toute nature qui transitent dans l'atmosphère, il faut effectuer des filtrages très sélectifs des signaux reçus, et ceci impose alors d'effectuer plusieurs transpositions de fréquences. Ces transpositions successives permettent de passer progressivement de la fréquence radio à une fréquence acceptable dans le circuit de traitement numérique.

A titre d'exemple, on peut utiliser deux changements successifs de fréquence pour passer de la fréquence L1 du GPS (1575,42 MHz) à une fréquence intermédiaire de l'ordre de quelques centaines de MHz, puis à une fréquence de l'ordre de 20 MHz.

On a déjà proposé, pour réduire le nombre d'oscillateurs locaux nécessaires pour faire la transposition de fréquence, dans le cas d'un GPS fonctionnant à la fois sur la fréquence L1 et sur la fréquence L2, de choisir comme fréquence intermédiaire une fréquence égale à environ 175 MHz, car alors le même oscillateur local, à une fréquence médiane entre L1 et L2 (environ 1400 MHz) peut servir pour transposer en fréquence à la fois les signaux à fréquence L1 et les signaux à fréquence L2; les signaux transposés peuvent alors passer dans les mêmes circuits (notamment les filtres) puisqu'ils sont dans la même bande étroite de fréquences autour de 175 MHz.

Par ailleurs, comme cela est bien connu, la transposition de fréquence se fait en principe par un mélangeur qui reçoit d'une part un signal à transposer et d'autre part le signal d'un oscillateur local; l'oscillateur local est réalisé à partir d'un oscillateur pilote, d'un diviseur de fréquence, et d'une boucle asservie en phase; un même oscillateur pilote peut alors servir pour réaliser plusieurs oscillateurs locaux, si on utilise plusieurs diviseurs de fréquence.

Enfin, pour ce qui concerne l'invention, on considérera que la dernière étape de transposition de fréquence peut s'effectuer soit dans un mélangeur (comme expliqué ci-dessus), soit dans le convertisseur analogique-numérique qui établit finalement le signal à destination du circuit de traitement numérique de signal. En effet, lorsque la fréquence d'échantillonnage Fₑ d'un convertisseur est inférieure au double de la fréquence centrale F_{c} du spectre du signal reçu par le convertisseur, le phénomène de repliement de spectre, bien connu dans les systèmes échantillonnés, fait que la fréquence du signal de sortie du convertisseur a un spectre centré autour de la fréquence différence Fₑ-F_{c}, ce qui est l'équivalent d'une transposition de fréquence de F_{c} à Fₑ-F_{c}.

On propose selon l'invention un circuit analogique de réception de signaux de satellites, comprenant des circuits de transposition de fréquence et un convertisseur analogique-numérique, caractérisé en ce que le circuit analogique comporte, pour faire la transposition de fréquence, au moins deux diviseurs de fréquence, dont le premier au moins est programmable pour fournir au moins les rapports de division suivants : 140 et 143.

On a trouvé que ces rapports offraient des possibilités remarquables pour permettre de choisir librement, sans changer de circuit et avec une programmation simple, le type de récepteur et l'application qu'on veut en faire parmi plusieurs types et applications différentes.

La programmation est particulièrement facile si le diviseur possède une entrée de commande électrique du rapport de division pour fournir le rapport choisi en fonction du signal établi sur cette entrée. Un simple bit de commande permet de choisir la valeur 140 ou 143.

De préférence, le deuxième diviseur a alors un rapport de division égal à 10 et il y a un troisième diviseur de rapport de 3. Mais le troisième diviseur est de préférence lui aussi programmable pour permettre de choisir, de préférence par une commande électrique, au moins l'un des trois rapports suivants : 3, 5, ou 7.

Pour élargir la gamme d'applications possibles sans changer la structure du circuit analogique, on s'arrange de préférence pour que le premier diviseur soit programmable pour avoir les valeurs 140, 143, et 137. Pour élargir encore, il peut être programmable pour fournir une quatrième valeur 142. Mais le premier diviseur peut également être programmable pour fournir toutes les valeurs entières entre 137 et 143, ou même entre 136 et 143.

Le troisième diviseur peut être programmable pour fournir également un rapport de division égal à 8.

Enfin, le deuxième diviseur peut être programmé pour fournir la valeur 10 ou la valeur 11, mais il n'est pas nécessaire de prévoir une commande séparée pour ce diviseur, la commande du troisième diviseur étant suffisante, associée à un décodeur très simple, pour déterminer le rapport du deuxième diviseur en fonction du rapport imposé au troisième diviseur : comme on le verra, la valeur 11 pour le deuxième diviseur sera en principe systématiquement associée à la valeur 8 pour le troisième.

D'une manière pratique, on prévoira de préférence que le circuit comporte trois diviseurs, et des moyens pour permettre d'obtenir au moins l'une des combinaisons de rapports de division suivantes, où N1, N2, et N3 désignent les rapports de division du premier, du deuxième, et du troisième diviseur respectivement :

| | | |
|---|---|---|
| N1 = 137 | N2 = 10 | N3 = 3 |
| N1 = 140 | N2 = 10 | N3 = 3 |
| N1 = 140 | N2 = 10 | N3 = 7 |
| N1 = 143 | N2 = 10 | N3 = 5 |
| N1 = 140 | N2 = 10 | N3 = 5 |
| N1 = 143 | N2 = 10 | N3 = 3 |
| N1 = 140 | N2 = 11 | N3 = 8 |
| N1 = 142 | N2 = 10 | N3 = 5 |

Ces combinaisons sont en effet celles qui offrent les meilleures possibilités pratiques d'utilisation du circuit analogique.

Les diviseurs de fréquence qui sont programmables peuvent être commandés indépendamment les uns des autres, mais on peut aussi prévoir à l'intérieur du circuit analogique un décodeur simple, à trois commandes d'entrée, pour sélectionner une combinaison de trois rapports de division parmi huit combinaisons possibles correspondant à des utilisations particulières prédéterminées du récepteur. Le décodeur a alors des sorties pour commander séparément les différents diviseurs.

D'autres caractéristiques et avantages de l'invention apparaîtront à la lecture de la description détaillée qui suit et qui est faite en référence aux dessins annexés dans lesquels :
- la figure 1 représente la constitution générale d'un circuit analogique de réception de signaux de satellites, avec un synthétiseur de fréquences fournissant trois fréquences destinées à faire des transpositions de fréquence;
- la figure 2 représente la constitution du synthétiseur de fréquence selon l'invention.

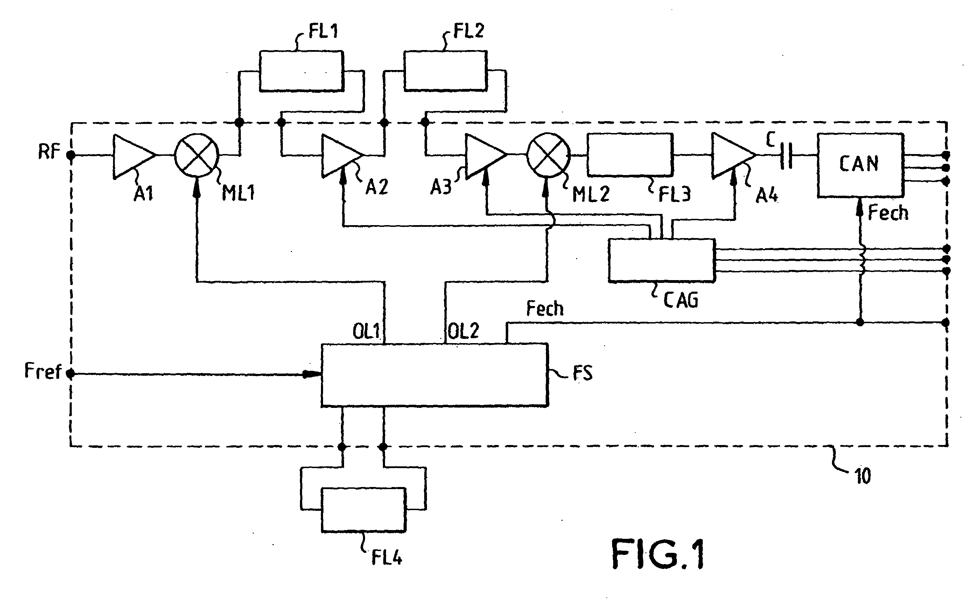

Sur la figure 1, on a représenté dans un cadre pointillé 10 les éléments de circuit qui font partie d'un circuit intégré analogique conçu pour effectuer la réception des signaux de satellites et pour fournir à un autre circuit intégré (non représenté), appelé circuit de traitement numérique de signal, des signaux numériques à une fréquence acceptable pour ce dernier circuit. Les signaux numériques fournis conservent la modulation de phase pseudo-aléatoire des signaux reçus des satellites.

Les signaux radiofréquence des satellites, reçus à travers une antenne de réception et éventuellement amplifiés par un préamplificateur non représenté, extérieur au circuit intégré 10, sont appliqués à une entrée RF du circuit intégré.

Dans le circuit intégré, les signaux radiofréquence passent dans un amplificateur A1 puis dans un premier mélangeur ML1 effectuant une première transposition de fréquence. Le mélangeur ML1 reçoit une fréquence locale OL1 d'un synthétiseur de fréquence FS qui fournit les différentes fréquences locales nécessaires aux transpositions de fréquence effectuées dans le circuit intégré. Le mélangeur produit des signaux dont la fréquence est la différence entre les fréquences présentes sur ses entrées.

A la sortie du mélangeur ML1, les signaux sont filtrés par un filtre FL1 pour ne conserver que les fréquences centrées autour de la différence entre la fréquence radio reçue (1200 MHz à 1600 MHz environ) et la fréquence locale OL1 (1350 à 1450 MHz environ). Cette différence est de 150 à 200 MHz environ et le filtre FL1 est un filtre passe-bande laissant passer uniquement les signaux dans cette dernière bande. Le filtre FL1 est de préférence extérieur au circuit intégré, comme cela est représenté, et ceci pour des raisons de faisabilité.

Les signaux ainsi filtrés sont des signaux transposés autour d'une première fréquence intermédiaire qui est la différence entre la fréquence nominale reçue du satellite et la fréquence locale OL1. Ils conservent la modulation de phase du signal satellite. Ces signaux reviennent dans le circuit intégré et sont à nouveau amplifiés dans un amplificateur A2, puis ils passent dans un deuxième filtre FL2, extérieur au circuit intégré, puis reviennent dans un amplificateur A3 du circuit intégré. Les amplificateurs A2 et A3, ainsi qu'un amplificateur A4 mentionné plus loin, sont de préférence des amplificateurs à gain commandé, et un circuit de commande automatique de gain CAG est prévu à cet effet. Ce circuit est commandé par le circuit de traitement numérique de signal et il ne sera pas plus détaillé car il ne fait pas l'objet de la présente invention.

Les signaux transposés à la première fréquence intermédiaire sont transmis de l'amplificateur A3 à un deuxième mélangeur ML2 qui les transpose à nouveau autour d'une deuxième fréquence intermédiaire. La deuxième fréquence intermédiaire est la différence entre la première fréquence intermédiaire et une deuxième fréquence locale OL2 produite par le synthétiseur de fréquence FS.

La deuxième fréquence locale OL2 est une fréquence de l'ordre de 120 à 150 MHz et la deuxième fréquence intermédiaire pourra être de 1 à 50 MHz.

Un filtre FL3, qui peut être interne au circuit intégré, laisse passer les signaux centrés autour de la deuxième fréquence intermédiaire, avec une bande passante suffisante pour prendre en compte les variations de fréquence de signaux satellites dues à l'effet Doppler, et suffisante pour pouvoir laisser passer aussi bien les signaux centrés autour d'une fréquence intermédiaire de 1MHz que les signaux centrés autour d'une fréquence de 50 MHz. Le filtre FL3 peut être un filtre passe-bas.

Les signaux de sortie du filtre FL3 sont appliqués au quatrième amplificateur A4, puis, à travers une capacité de découplage C, à un convertisseur analogique-numérique CAN. Le convertisseur fournit sur des sorties S1, S2, S3 des signaux numériques (dans cet exemple les signaux sont codés sur trois bits) représentant l'amplitude d'échantillons de signaux analogiques reçus du satellite et transposés autour de la deuxième fréquence intermédiaire. L'échantillonnage se fait à une fréquence Fech qui provient du synthétiseur de fréquence FS, mais qui dans certains cas pourrait provenir de l'extérieur du circuit intégré.

Dans le cas général, le convertisseur doit avoir une fréquence d'échantillonnage supérieure à deux fois la fréquence maximale des signaux à convertir. Cependant, le convertisseur peut difficilement avoir une fréquence d'échantillonnage supérieure à 50 MHz. Par conséquent, lorsque la deuxième fréquence intermédiaire est relativement élevée (par exemple au dessus de 25 MHz), il faut faire une troisième transposition de fréquence.

Cette troisième transposition de fréquence peut être faite avec un troisième mélangeur et une troisième fréquence locale OL3. Cependant, on peut également considérer que la fréquence d'échantillonnage Fech du convertisseur CAN constitue cette troisième fréquence locale de sorte que le convertisseur effectue lui-même cette troisième transposition de fréquence. Ceci résulte du phénomène connu de repliement de spectre des signaux échantillonnés lorsque la fréquence d'échantillonnage est inférieure au double de la fréquence des signaux à échantillonner : lorsque le spectre de fréquence du signal à échantillonner est centré autour d'une fréquence F_{c} (en l'occurence la deuxième fréquence intermédiaire), le signal de sortie après échantillonnage à la fréquence F_{ech} est le même que si on avait au préalable effectué une transposition de fréquence de F_{c} à F_{ech}-F_{c}.

Par conséquent, on considérera pour cette invention que le convertisseur analogique-numérique joue lorsque cela est nécessaire, outre son rôle de conversion proprement dit, un rôle de dernière transposition de fréquence dans la chaîne de traitement du signal analogique. Et cette dernière transpositin de fréquence utilise comme fréquence locale OL3 la fréquence d'échantillonnage F_{ech}.

Les trois fréquences locales sont produites par un synthétiseur de fréquence FS dont le fonctionnement est synchronisé par une fréquence de référence stable F_{ref} fournie par un oscillateur pilote non représenté, extérieur au circuit intégré (en principe un oscillateur à quartz). Le synthétiseur peut par ailleurs utiliser pour son fonctionnement un filtre FL4 extérieur au circuit intégré.

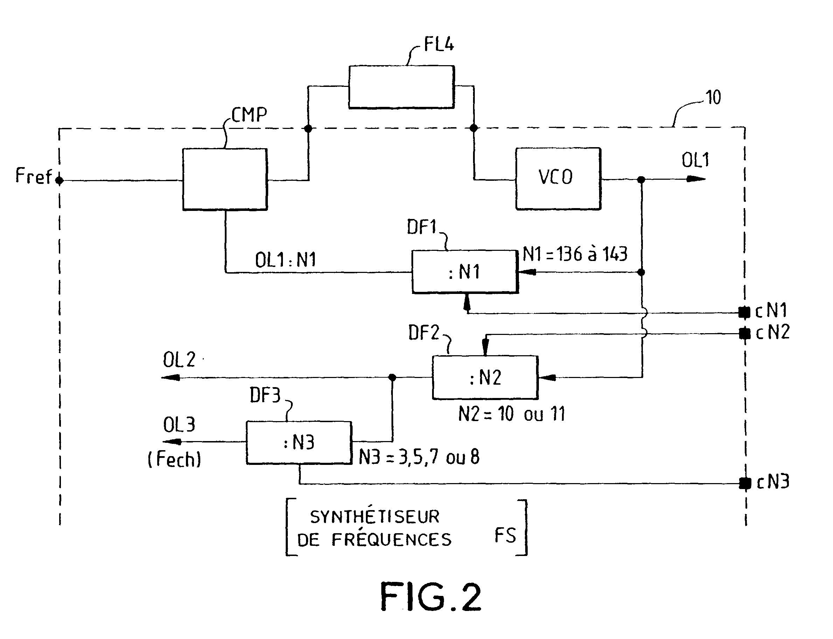

La figure 2 rappelle schématiquement le fonctionnement d'un synthétiseur de fréquences fonctionnant avec une boucle d'asservissement de phase et des diviseurs de fréquence. La fréquence de référence F_{ref} de l'oscillateur pilote est appliquée à une entrée d'un comparateur de phase CMP dont une autre entrée reçoit une fréquence sous-multiple de la première fréquence locale OL1. Le comparateur de phase produit des créneaux dont la largeur représente le déphasage entre les fréquences présentes sur les deux entrées. Ces créneaux sont intégrés et filtrés dans un filtre de boucle de phase FL4 et produisent une tension de commande d'un oscillateur commandé par une tension (VCO). L'oscillateur produit une fréquence dépendant de la tension de commande qu'il reçoit. Cette fréquence est divisée par un premier diviseur de fréquence DF1. La boucle d'asservissement ajuste en permanence la tension de commande de l'oscillateur pour maintenir synchrones les deux fréquences reçues par le comparateur de phase, c'est-à-dire la fréquence pilote F_{ref} et la fréquence de sortie du premier diviseur. La fréquence OL1 produite par le synthétiseur est la fréquence de l'oscillateur VCO. L'asservissement maintient donc cette fréquence égale à N1 fois la fréquence pilote, N1 étant le rapport de division du premier diviseur DF1.

La sortie de l'oscillateur VCO, à fréquence OL1, est appliquée à un autre diviseur de fréquence DF2, de rapport N2, pour produire la fréquence OL2. Un troisième diviseur de fréquence DF3 de rapport N3, reçoit dans cet exemple la sortie du deuxième diviseur et produit la fréquence OL3 qui sera de préférence directement la fréquence d'échantillonnage F_{ech}.

N1, N2 et N3 sont des nombres entiers.

La difficulté réside, comme on l'a expliqué, dans le choix des rapports de division N1, N2 et N3, liés d'ailleurs au choix de la fréquence pilote F_{ref}, pour rendre le circuit intégré le plus universel possible, c'est-à-dire le plus indépendant possible du type de récepteur (GPS ou GLONASS ou mixte) et de l'application qu'on veut en faire (usage des fréquences L1 seulement, ou des fréquences L1 et L2).

Les valeurs remarquables de N1 selon l'invention sont principalement 140 et 143.

N2 prend de préférence la valeur 10. Si N3 ne doit prendre qu'une valeur, c'est la valeur 3. Mais N3 peut de préférence prendre l'une des trois valeurs suivantes : 3, 5, ou 7. Une quatrième valeur est également intéressante, à savoir la valeur 8. Dans ce dernier cas, on prévoit que N2 peut prendre l'une des deux valeurs 10 et 11, la valeur 11 étant choisie lorsque N3 = 8.

Enfin, la valeur N1 = 137 s'avère également intéressante en plus des valeurs 140 et 143, et, plus rarement, la valeur 142.

Le synthétiseur de fréquence est donc conçu de préférence de telle sorte que le rapport de division N1 soit commandable à partir d'une ou plusieurs bornes du circuit intégré analogique, de manière que le rapport puisse être modifié par un signal électrique de commande, en fonction de l'application désirée. On pourrait envisager que N1 (comme N2 et N3 d'ailleurs) soit programmable par masque (lors de la fabrication du circuit) plutôt que par une commande électrique; dans ce cas on aboutit à des circuits intégrés très légèrement différents selon l'application désirée. Il est cependant préférable que la commande soit électrique et faite par des bornes d'accès au circuit intégré. On pourrait aussi envisager que la modification de valeur de N1 soit faite par configuration définitive du circuit intégré à une étape finale de fabrication, par exemple en grillant un ou plusieurs fusibles de routage de signaux. Cette configuration tardive, qui détermine la valeur N1 (et/ou N2 ou N3) peut être faite par exemple lors du test sur tranche des circuits intégrés en cours de fabrication.

Si N1 doit prendre seulement deux valeurs possibles (140 et 143), et si la commande est électrique, un seul plot de commande suffit (un bit de commande) pour commander le diviseur DF1. Si N1 doit prendre trois ou quatre valeurs, il faut deux fils. Une solution consiste cependant à utiliser trois plots de commande (3 bits donc huit valeurs possibles) pour choisir une valeur N1 quelconque parmi les entiers de 136 à 143 inclus.

N3 prend de préférence trois valeurs possibles, et éventuellement une quatrième. Deux plots de commande sont donc souhaitables.

N2 peut être soit fixe (N2 = 10) soit commandé par un plot pour obtenir soit la valeur 10 soit la valeur 11. Cependant, comme N2 prendra la valeur 11 dès lors que N3 prendra la valeur 8, on peut se dispenser de plot de commande de N2. Un simple petit décodeur placé sur les fils de commande du diviseur DF3 détectera la commande correspondant à N3 = 8 et commandera alors le diviseur DF2 pour lui faire prendre le rapport de division N2=11.

Enfin, plutôt que de prévoir trois plots d'entrée pour la commande de N1, et deux pour la commande de N3, on peut prévoir trois plots de commande (trois bits donc huit possibilités) pour commander globalement, grâce à un décodage simple prévu dans le circuit intégré des combinaisons particulières de N1, N2, et N3; par exemple la combinaison N1 = 140, N2 = 10, et N3 = 3 correspondrait à un état particulier du groupe de trois plots de commande.

Les paragraphes ci-après expliquent en détail l'utilisation de l'invention en donnant les valeurs de N1, N2, N3 pour les différentes applications envisagées, avec la fréquence pilote F_{ref} qui correspond à chaque cas. La valeur de la fréquence pilote peut en effet être quelconque mais elle influe directement sur les choix des rapports de division. On a trouvé qu'en utilisant seulement les deux fréquences pilotes 10 MHz et 10,23 MHz avec les différents rapports de division ci-dessus on aboutissait au moins aux possibilités des paragraphes suivants (les plus intéressantes). On comprendra qu'avec d'autres fréquences pilotes convenablement choisies on élargit encore la gamme des possibilités.

Pour chaque cas on donnera la fréquence d'horloge de référence à utiliser, les rapports de division N1, N2, N3, le type de récepteur et son utilisation. On donnera ensuite, d'abord pour les fréquences L1 puis pour les fréquences L2 : les fréquences d'oscillateur local OL1, OL2 et OL3 produites par le synthétiseur de fréquences, les fréquences intermédiaires F1, F2, et la fréquence F3 qui en résultent (ou les bandes de fréquences dans le cas de GLONASS).
1.
   F_{ref} = 10,23 MHz
   N1=137 N2=10 N3=3
   Récepteur GPS, usage civil et militaire avec fréquences L1 et L2
   a) pour la fréquence L1 :
      fréquence fondamentale à 1575,42 MHz
      LO1 = 1401,51 F1= 173,91 HMz
      LO2= 140,151 MHz F2 = 33,759 MHz
      OL3 = 46,717 MHz F3 = 12,958 MHz
   b) pour la fréquence L2 :
      fréquence fondamentale à 1227,60 MHz
      OL1 = 1401,51 MHz F1 = 173,91 MHz
      OL2 = 140,151 MHz F2 = 33,759 MHz
      OL3 = 46,717 MHz F3 = 12,958 MHz
2.
   F_{ref} = 10 MHz
   N1=140 N2=10 N3=3
   Récepteur GPS, usage civil et militaire avec fréquence L1 et L2
   a) pour la fréquence L1 :
      fréquence fondamentale à 1575,42 MHz
      OL1 = 1400 MHz F1 = 175,42 MHz
      OL2 = 140 MHz F2 = 35,42 MHz
      OL3 ≃ 46,667 MHz F3 ≃ 11,247 MHz
   b) pour la fréquence L2 :
      OL1 = 1400 MHz F1= 172,40 MHz
      OL2 = 140 MHz F2 = 32,40 MHz
      OL3 ≃ 46,667 MHz F3 ≃ 17,267 MHz
3.
   F_{ref} = 10 MHz
   N1=140 N2=10 N3=7
   Récepteur GPS standard civil avec usage de L1 seulement
   fréquence fondamentale 1575,42 MHz
   OL1 = 1400 MHz F1 = 175,42 MHz
   OL2 = 140 MHz F2 = 35,42 MHz
   OL3 = 20 MHz F3 = 15,42 MHz
4.
   F_{ref} =10 MHz
   N1=143 N2=10 N3=5
   Récepteur GLONASS civil pour les années après 1998 où la bande L1 ira de 1598 MHz à 1610 MHz
   fréquences fondamentales : 1598 MHz à 1610 MHz
   OL1 = 1430 MHz F1 va de 168 MHz à 180 MHz
   OL2 = 143 MHz F2 va de 25 MHz à 37 MHz
   OL3 = 28,6 MHz F3 va de 0 MHz à 8,4 MHz
5.
   F_{ref} = 10 MHz
   N1 = 140 N2 = 10 N3 = 5
   Récepteur GPS standard civil utilisant la fréquence L1
   OL1 = 1400 MHz F1 = 175,42 MHz
   OL2 = 140 MHz F2 = 35,42 MHz
   OL3 = 28 MHz F3 = 7,42 MHz
6.
   F_{ref} = 10 MHz
   N1 = 143 N2 = 10 N3 = 3
   Récepteur GLONASS militaire utilisant les fréquences L1 et L2
   a) fréquences L1 de 1598 MHz à 1620 MHz
      OL1 = 1430 MHz F1 va de 168 MHz à 190 MHz
      OL2 = 143 MHz F2 va de 25 MHz à 47 MHz
      OL3 ≃ 47,667 MHz F3 va de 0,666 MHz à 22,666MHz
   b) fréquences L2 de 1240 à 1263
      OL1 = 1430 MHz F1 va de 167 MHz à 190 MHz
      OL2 = 143 MHz F2 va de 24 MHz à 47 MHz
      OL3 ≃ 47,666 MHz F3 va de 0,666 MHz à 23,666MHz
7.
   F_{ref} = 10 MHz
   N1 = 140 N2 = 11 N3 = 8
   GPS civil bas de gamme
   Fréquence fondamendale : 1575,42 MHz
   OL1 = 1400 MHz F1 = 175,42 MHz
   OL2 = 127,272 MHz F2 = 48,148 MHz
   OL3 = 15,909 MHz F3 = 32,24 MHz
8.
   F_{ref}=10 MHz
   N1=142 N2=10 N3=5
   Récepteur GLONASS civil futur utilisant la bande de fréquence L1 après l'année 2005
   fréquences L1 allant de 1598 à 1605
   OL1 = 1420 MHz F1 va de 178 MHz à 185MHz
   OL2 = 142 MHz F2 va de 36 MHz à 43MHz
   OL3 = 28,4 MHz F3 va de 7,6MHz à 14,6 MHz

Ainsi, quelques combinaisons simples de valeurs des trois diviseurs N1, N2, N3, combinées pour la plupart d'entre elles avec l'utilisation d'une fréquence de référence de 10 MHz (particulièrement facile à se procurer), permettent d'assurer huit utilisations possibles du circuit sans rien changer à celui-ci (les filtres à fréquences intermédiaires en particulier peuvent être les mêmes pour tous les circuits).

## Revendications

1. Circuit analogique de réception de signaux de satellites GPS ou GLONASS, comprenant des circuits de transposition de fréquence et un convertisseur analogique-numérique (CAN), les circuits de transposition de fréquence comprenant au moins un oscillateur pilote (VCO) et deux diviseurs de fréquence (DF1, DF2) reliés à la sortie de l'oscillateur pilote pour produire des fréquences proportionnelles à la fréquence de l'oscillateur pilote, ces fréquences étant utilisées pour l'élaboration des signaux transposés en fréquence, le premier diviseur de fréquence étant utilisé dans une boucle d'asservissement de la fréquence de l'oscillateur pilote, **caractérisé en ce que**, en vue de faciliter la transposition de fréquence pour des signaux de satellites à des fréquences différentes, le premier diviseur de fréquence (DF1) est programmable pour fournir au moins les rapports de division suivants : 140 et 143.

2. Circuit analogique selon la revendication 1, **caractérisé en ce que** les rapports de division peuvent être choisis à l'aide d'une commande électrique du rapport de division.

3. Circuit analogique selon l'une des revendications 1 et 2, **caractérisé en ce que** le deuxième diviseur a un rapport de division égal à 10 et le circuit comporte un troisième diviseur de rapport de 3.

4. Circuit analogique selon l'une des revendications 1 et 2, **caractérisé en ce que** le deuxième diviseur a un rapport de division égal à 10 et le circuit comporte un troisième diviseur de rapport programmable permettant de choisir au moins l'un des trois rapports suivants : 3, 5, ou 7.

5. Circuit analogique selon l'une des revendications précédentes, **caractérisé en ce que** le premier diviseur est programmable pour avoir les valeurs 140, 143, et 137

6. Circuit analogique selon la revendication 5, **caractérisé en ce que** le premier diviseur peut fournir également la valeur 142.

7. Circuit analogique selon la revendication 5, **caractérisé en ce que** le premier diviseur est programmable pour fournir toutes les valeurs entières entre 137 et 143, ou entre 136 et 143.

8. Circuit analogique selon l'une des revendications 3 et 4, **caractérisé en ce que** le troisième diviseur peut fournir la valeur de division 8 et le deuxième peut fournir la valeur de division 11.

9. Circuit analogique selon la revendication 1, **caractérisé en ce qu'**il comporte un troisième diviseur et des moyens pour permettre d'obtenir au moins l'une des combinaisons de rapports de division suivantes, où N1, N2, et N3 désignent les rapports de division du premier, du deuxième, et du troisième diviseur respectivement :
| | | |
|---|---|---|
| N1 = 137 | N2 = 10 | N3 = 3 |
| N1 = 140 | N2 = 10 | N3 = 3 |
| N1 = 140 | N2 = 10 | N3 = 7 |
| N1 = 143 | N2 = 10 | N3 = 5 |
| N1 = 140 | N2 = 10 | N3 = 5 |
| N1 = 143 | N2 = 10 | N3 = 3 |
| N1 = 140 | N2 = 11 | N3 = 8 |
| N1 = 142 | N2 = 10 | N3 = 5 |

## Patentansprüche

1. Analoge Schaltung zum Empfang von GPS- oder GLONASS-Satellitensignalen, mit Schaltungen zur Frequenzumsetzung und einem Analog-Digitalwandler (CAN), wobei die Schaltungen zur Frequenzumsetzung mindestens einen Pilotoszillator (VCO) sowie zwei Frequenzteiler (DF1, DF2) aufweisen, die an den Ausgang des Pilotoszillators angeschlossen sind und Frequenzen proportional zur Frequenz des Pilotoszillators erzeugen, welche dann zur Frequenzumsetzung verwendet werden, wobei der erste Frequenzteiler in einer Frequenzregelschleife des Pilotoszillators verwendet wird, **dadurch gekennzeichnet, daß** zur Vereinfachung der Frequenzumsetzung der Satellitensignale auf unterschiedliche Frequenzen der erste Frequenzteiler (DF1) so programmierbar ist, daß er mindestens die Teilerverhältnisse 140 und 143 liefert.

2. Analoge Schaltung nach Anspruch 1, **dadurch gekennzeichnet, daß** die Teilerverhältnisse mithilfe einer elektrischen Steuerung des Teilerverhältnisses gewählt werden können.

3. Analoge Schaltung nach einem der Ansprüche 1 und 2, **dadurch gekennzeichnet, daß** der zweite Teiler ein Teilerverhältnis von 10 und ein dritter Teiler vorgesehen ist, der ein Teilerverhältnis von 3 hat.

4. Analoge Schaltung nach einem der Ansprüche 1 und 2, **dadurch gekennzeichnet, daß** der zweite Teiler ein Teilerverhältnis von 10 besitzt und daß die Schaltung einen dritten Teiler besitzt, dessen Teilerverhältnis programmierbar ist und mindestens einen der drei Teilerverhältnisse 3, 5 und 7 zu wählen erlaubt.

5. Analoge Schaltung nach einem der vorstehenden Ansprüche, **dadurch gekennzeichnet, daß** der erste Teiler so programmierbar ist, daß er die Werte 140, 143 und 137 der Teilerverhältnisse annehmen kann.

6. Analoge Schaltung nach Anspruch 5, **dadurch gekennzeichnet, daß** der erste Teiler auch den Wert 142 liefern kann.

7. Analoge Schaltung nach Anspruch 5, **dadurch gekennzeichnet, daß** der erste Teiler so programmierbar ist, daß er alle ganzzahligen Werte zwischen 137 und 143 oder zwischen 136 und 143 liefern kann.

8. Analoge Schaltung nach einem der Ansprüche 3 und 4, **dadurch gekennzeichnet, daß** der dritte Teiler das Teilerverhältnis 8 und der zweite das Teilerverhältnis 11 liefern kann.

9. Analoge Schaltung nach Anspruch 1, **dadurch gekennzeichnet, daß** sie einen dritten Teiler enthält und Mittel, die es erlauben, mindestens eine der nachfolgenden Kombinationen von Teilerverhältnissen zu erhalten, wobei N1, N2 und N3 die Teilerverhältnisse des ersten bzw. zweiten bzw dritten Teilers bezeichnen:
| | | | | | | | | |
|---|---|---|---|---|---|---|---|---|
| N1= | 137 | 140 | 140 | 143 | 140 | 143 | 140 | 142 |
| N2= | 10 | 10 | 10 | 10 | 10 | 10 | 11 | 10 |
| N3= | 3 | 3 | 7 | 5 | 5 | 3 | 8 | 5 |

## Claims

1. Analogue circuit for receiving GPS or GLONASS satellite signals, comprising frequency transposition circuits and an analogue/digital converter (ADC), the frequency transposition circuits comprising at least one pilot oscillator (VCO) and two frequency dividers (DF1, DF2) linked to the output of the pilot oscillator so as to produce frequencies proportional to the frequency of the pilot oscillator, these frequencies being used for the formulation of the frequency-transposed signals, the first frequency divider being used in a loop for locking the frequency of the pilot oscillator, **characterized in that**, with a view to easing the frequency transposition in respect of satellite signals at different frequencies, the first frequency divider (DF1) is programmable so as to provide at least the following division ratios: 140 and 143.

2. Analogue circuit according to Claim 1, **characterized in** the that the division ratios may be chosen with the aid of electrical control of the division ratio.

3. Analogue circuit according to one of Claims 1 and 2, **characterized in that** the second divider has a division ratio equal to 10 and the circuit comprises a third divider with ratio 3.

4. Analogue circuit according to one of Claims 1 and 2, **characterized in that** the second divider has a division ratio equal to 10 and the circuit comprises a third divider with programmable ratio making it possible to choose at least one of the following three ratios: 3, 5 or 7.

5. Analogue circuit according to one of the preceding claims, **characterized in that** the first divider is programmable so as to have the values 140, 143 and 137.

6. Analogue circuit according to Claim 5, **characterized in that** the first divider can also provide the value 142.

7. Analogue circuit according to Claim 5, **characterized in that** the first divider is programmable so as to provide all the integer values between 137 and 143, or between 136 and 143.

8. Analogue circuit according to one of Claims 3 and 4, **characterized in that** the third divider can provide the division value 8 and the second can provide the division value 11.

9. Analogue circuit according to Claim 1, **characterized in that** it comprises a third divider and means for making it possible to obtain at least one of the following combinations of division ratios, where N1, N2 and N3 denote the division ratios of the first, second and third divider respectively:
| | | |
|---|---|---|
| N1 = 137 | N2 = 10 | N3 = 3 |
| N1 = 140 | N2 = 10 | N3 = 3 |
| N1 = 140 | N2 = 10 | N3 = 7 |
| N1 = 143 | N2 = 10 | N3 = 5 |
| N1 = 140 | N2 = 10 | N3 = 5 |
| N1 = 143 | N2 = 10 | N3 = 3 |
| N1 = 140 | N2 = 11 | N3 = 8 |
| N1 = 142 | N2 = 10 | N3 = 5 |
